# EUROPÄISCHE PATENTANMELDUNG

(11) **EP 1 818 269 A2**
(43) Veröffentlichungstag der Anmeldung: **15.08.2007**
(21) Anmeldenummer: 07002673.7
(22) Anmeldetag: 07.02.2007
(51) Int. Cl.: B65D 6/16, B65D 19/02

(54) **Transport- und Verpackungsbehälter**

(30) Priorität: 08.02.2006 AT 1942006
(71) Anmelder: Gebesmair, Manfred, 4550 Kremsmünster (AT)
(72) Erfinder: Gebesmair, Manfred, 4550 Kremsmünster (AT)
(74) Vertreter: Ofner, Clemens

(57) **Zusammenfassung**

Die Erfindung beschreibt einen zerlegbaren Transport- und Verpackungsbehälter (1) mit abnehmbarer Boden- und Deckelteil mit jeweils annähernd vertikal angeordneten Randstegen (4) sowie an der Bodenplatte (2) entlang den Randstegen (4) aufstellbaren Seitenwänden (5), insbesondere zwei Seiten- (5) und zwei Stirnwänden (6) mit Randbereichen (9) an ihrer Innen- (7) und Außenseite (8) und mit Stirnseiten (10) bzw. -flächen (11). Die Seitenwände (5) sind scharnierlos auf dem Boden- und Deckelteil angeordnet und an zumindest zwei Seitenwänden (5) in zumindest einem Randbereich (9) der Innenseite (7) ist zumindest ein Steg (16) ausgebildet bzw. angeordnet und/oder die Stirnseiten (10) der Seitenwände (5), die benachbart zur Stirnfläche (11) einer weiteren Seitenwand (5) angeordnet sind, sind auf Gehrung in Bezug auf die Innenseite (7) der jeweiligen Seitenwand (5) angeordnet.

## Beschreibung

Die Erfindung betrifft einen zerlegbaren Transport- und Verpackungsbehälter mit abnehmbarem Boden- und Deckelteil mit jeweils annähernd vertikal angeordneten Randstegen sowie an der Bodenplatte entlang den Randstegen aufstellbaren Seitenwänden, insbesondere je zwei Seiten- und Stirnwänden mit Randbereichen an ihrer Innen- und Außenseite und mit Stirnseiten bzw. -flächen, ein Verfahren zu dessen Herstellung und dessen Verwendung.

Transportkisten dienen oft als Mehrwegverpackung und sollen einerseits zur Aufnahme der Transportgüter ein entsprechend großes Fassungsvermögen aufweisen und andererseits für den Rücktransport als Leegut möglichst wenig Platz in Anspruch nehmen. Es wurde daher schon vorgeschlagen, die Transportkisten aus Einzelteilen herzustellen, die sich durch einfache Hakenverbindungen schnell und geschickt aufstellen und zusammenlegen lassen. Allerdings verlangen diese bekannten Kisten zum Zusammenlegen ein recht umständliches Ineinanderschachteln der Teile und es entsteht nur ein loses, leicht auseinander fallendes Paket. Außerdem kann auch der Deckel der Kiste nicht fixiert werden, sodass jederzeit ein ungewolltes Öffnen der Kiste zu befürchten ist.

In der AT 182 077 wird eine Kiste beschrieben, bei welcher Kistenwände durch gegen seitliche Verschiebung gesicherte, in ihrer Längsrichtung jedoch verschiebbare Bindeglieder, wie Bänder oder Seile, die an beiden Stirnwänden nur über deren halbe Breite festgelegt sind, zusammengehalten sind. Durch diese Ausbildung wird auf einfache und billige Weise eine Transportkiste geschaffen, die sich nach Entleerung ihres Inhalts zu einem Gebilde mit geringsten Raumbedarf zusammenklappen lässt und dessen Zusammenhalt, zumindest was die Seiten- und die Stirnwände anbetrifft, durch die bereits vorhandenen Mittel gesichert ist. Als Bindeglieder werden Bandeisen verwendet, wobei deren Anbringung so erfolgt, dass einerseits die Stirnwände gegen die Seitenwände nach innen geklappt werden können und andererseits die an diesen Wänden festgelegten Bänder die Klappbewegung nicht behindern.

Eine zusammenlegbare Verpackungs- und Transportkiste ohne Scharniere ist aus der DE 42 18 346 A1 bekannt. Hierfür weisen zwei Wände jeweils eine Bodenleiste auf, die seitlich unter die Bodenplatte greift. Zwei der Wände sind mit Anschlagführungen und zwei der Wände sind mit Führungsleisten versehen. Bei in die Anschlagführungen eingeschobenen Führungsleisten sind die vier Wände horizontal formschlüssig aneinander gehalten.

In einem weiteren Dokument zum Stand der Technik, der US 2,868,406 wird ebenfalls ein zusammenlegbarer Transportbehälter beschrieben. Der zusammenlegbare Transportbehälter besteht aus einer Basis, welche gelenkig mit Seitenwänden verbunden ist, und die Basis entlang ihres Umfangs vertikal nach oben stehende Flansche aufweist.

Es sind auch zusammenklappbare Kisten bekannt, deren einzelne Teile durch Bänder und Scharniere miteinander verbunden sind. Die Verwendung von Scharnieren verteuert die Herstellung solcher Kisten jedoch, womit sie für allgemeine Transportzwecke nicht in Betracht kommen und zumal die damit verbundenen Metallbeschläge zu einer unrationellen Erhöhung des Leergewichtes Anlass geben. Dazu kommt noch, dass die dem Regen und den Witterungseinflüssen schutzlos preisgegebenen Scharnierverbindungen nach kurzer Zeit rosten, wodurch die Beweglichkeit der Scharniere stark beeinträchtigt und das Zusammenklappen der Kiste mit der Zeit unmöglich gemacht wird.

Aufgabe der vorliegenden Erfindung ist es einen zerlegbaren Transport- und Verpackungsbehälters, welcher sehr kostengünstig herstellbar aber dennoch strapazierfähig ist, zur Verfügung zu stellen.

Die Aufgabe der vorliegenden Erfindung wird eigenständig durch einen zerlegbaren Transport- und Verpackungsbehälter gelöst, wobei die Seitenwände scharnierlos auf der Bodenplatte angeordnet sind und an zumindest zwei Seitenwänden in zumindest einem Randbereich der Innenseite zumindest ein Steg ausgebildet bzw. angeordnet ist und/oder die Stirnseiten der Seitenwände, die benachbart zur Stirnfläche der weiteren Seitenwand angeordnet sind, auf Gehrung in Bezug auf die Innenseite der jeweiligen Seitenwand angeordnet sind. Durch die scharnierlose Ausbildung ist eine sehr kostengünstige Herstellung möglich. Scharniere sind meist aus einem Metall hergestellt und tendieren dazu, bei Kontakt mit Feuchtigkeit Rost anzulagern bzw. zu bilden. Dieser Effekt kann durch die scharnierlose Ausbildung verhindert werden. Durch die äußerst flexible Anordnung der Seitenwände wird der Zusammenbau eines Transport- und Verpackungsbehälters ermöglicht, der sich sehr einfach an die Form des zu verpackenden Materials anpassen lässt. Zudem wird durch die flexible Anordnung der Seitenwände ermöglicht, dass z.B. drei Seitenwände aufgestellt werden und die vordere Seitenwand oder eine der beiden Stirnwände so lange nicht aufgestellt werden, bis das zu verpackende Gut innerhalb der drei bereits aufgestellten Seitenwände angeordnet ist und zuletzt die frontale Seitenwand bzw. eine der beiden Stirnwände angeordnet werden. Somit ist eine sehr einfache Beladung des Transport- und Verpackungsbehälters möglich. Vorteilhaft erweist sich auch, dass durch das flexible System eine gebrochene Wand sehr einfach ausgetauscht und durch eine neue Wand ersetzt werden kann. Von Vorteil ist auch dass der Behälter sehr einfach und rasch aufgebaut werden kann um beispielsweise Güter zu verpacken, die für Wartungsarbeiten transportiert werden müssen. Wird der Transport- und Verpackungsbehälters zerlegt und gelagert um später wieder für einen Transport verwendet zu werden, nimmt dieser nur ein sehr geringes Volumen ein und kann daher Platz sparend gelagert werden.

Durch die Anordnung eines Stegs wird verhindert, dass die Seiten- bzw. Stirnwände in Richtung Innenraum des Transport- und Verpackungsbehälters fallen.

Der Vorteil der Anordnung der Seiten- bzw. Stirnwände auf Gehrung liegt darin, dass die Kontakt- bzw. Verbindungsfläche der zu verbindenden Seiten- bzw. Stirnwände vergrößert wird, was die Stabilität des Transport- und Verpackungsbehälters erhöht.

In einer bevorzugten Ausführungsform weisen die Stirnflächen in Bezug auf die Innenflächen der Seitenwände einen Winkel aus einem Bereich mit einer unteren Grenze von 15°, vorzugsweise 25°, insbesondere 35° und einer oberen Grenze von 75°, vorzugsweise 65°, insbesondere 55° auf, wodurch schon allein durch die Ausgestaltung der Stirnflächen der Seitenwände auf Gehrung eine optimale Position in Bezug auf die Stabilität der einzelnen Seiten-bzw. Stirnwände zueinander erzielt werden kann.

In einer speziellen Ausführungsform ist die Gehrung nicht die Winkelhalbierende des Winkels der beiden zu verbindenden Seiten- bzw. Stirnwände, wodurch je nach Bedarf bei Anordnung zweier Wände z.B. unter 90° eine Stirnfläche einer Seitenwand einen Winkel von 35° und eine Stirnfläche einer Stirnwand einen Winkel von 55° aufweisen kann, wodurch die Flexibilität des Transport- und Verpackungsbehälters weiter erhöht wird.

In einer Weiterbildung ist vorgesehen, dass der Steg einstückig mit der Seitenwand oder separat an der Seitenwand und durch eine Erhebung wie Leiste, Knauf, Knopf, Dübel, oder dgl. gebildet ist, wodurch ein Umfallen der Seitenwand in Richtung des Innenraumes des Transport-bzw. Verpackungsbehälters ausgeschlossen werden kann.

Ist der Steg an einer Seitenwand angeordnet, an welcher in der Gebrauchslage die Stirnflächen zwei einander gegenüber angeordneter Stirnwände an den Innenseiten der jeweils beiden gegenüberliegenden Seitenwände anliegen, so wird ein nach innen Fallen aller vier Seitenwände verhindert.

Das nach innen Fallen wird ebenfalls durch die Anordnung des Stegs an einer Stirnwand verhindert, an welcher in der Gebrauchslage die Stirnflächen zwei einander gegenüber angeordneter Seitenwände an den Innenseiten der jeweils beiden gegenüberliegenden Stirnwände anliegen.

Der Steg kann durchgehend über die gesamte Längserstreckung im Randbereich einer Seitenwand angeordnet sein, wodurch, unabhängig von der Lage bzw. des Einsatzes der Seitenwand, Oben und Unten beliebig vertauscht werden kann und in jedem Fall ein Steg zur Verfügung steht, der ein Umfallen der Seitenwand in Richtung des Innenraums des Verpackungsbehälters ausschließt. Durch die Anordnung des Stegs über die gesamte Längserstreckung wird auch eine höhere Stabilität der Seitenwände zueinander erzielt, weil eine größere Anlagefläche zur Verfügung steht.

In einer alternativen Ausführungsform kann der Steg nur bereichsweise entlang der Längserstreckung im Randbereich zumindest einer Seitenwand angeordnet sein, wodurch das Gewicht des Verpackungsbehälters, insbesondere im Leerzustand, so gering wie möglich gehalten werden kann.

Der zumindest eine Steg kann durch Nägel, Schrauben, Klammern, Haftkleber etc. an einer Stirn- oder Seitenwand befestigt sein, wodurch sehr einfache Befestigungsmöglichkeiten mit geringem Arbeits- und auch finanziellen Aufwand verwendet werden, um den Steg anzubringen.

Die Randstege können jeweils an der Stirnseite der Boden- und/oder Deckplatte angeordnet sein, wodurch unter optimaler Ausnützung der Abmessungen der Boden- bzw. der Deckplatte ein Verpackungsbehälter hergestellt wird.

In einer alternativen Ausführungsform können die Randstege auch im Randbereich der Innenseite der Boden- und/oder der Deckplatte angeordnet sein, wodurch eine größere Höhe der Randstege erzielt wird und somit der Halt der Seitenwände innerhalb der Randstege verbessert wird.

Um einen stark strapazierfähigen Boden bzw. Deckel zur Verfügung zu stellen können die Randbereiche benachbarter Randstege über Zinken, insbesondere Fingerzinken, offene Zinkung, halbverdeckte Zinkutig, Gehrungszinkung, etc. miteinander verbunden sein.

Die Randstege und die Seitenwände können, insbesondere durch Nägel, miteinander verbunden werden, wodurch eine einfache und zugleich kostengünstige Verbindungsweise zur Verfügung gestellt wird, die aber bei Bedarf auch wieder sehr einfach aufgelöst werden kann.

Die Boden- und Deckplatte können viereckig, insbesondere rechteckig oder quadratisch ausgebildet sein, und vier Seitenwände angeordnet haben, wodurch ein standardisierter Verpackungs- und Transportbehälter hergestellt wird, der beispielsweise auf Schiffen oder in Güterzügen Platz sparend transportiert werden kann.

Wird die Boden- und/oder Deckplatte rechteckig ausgebildet, so können die zwei einander gegenüberliegende Seiten- und zwei einander gegenüberliegende Stirnwände die gleichen Abmessungen aufweisen, wobei die jeweils zwei einander gegenüberliegenden Seitenwände symmetrisch angeordnet sind und somit ein symmetrischer Transportbehälter hergestellt werden kann.

In einer alternativen Ausführungsform können auch jeweils zwei einander gegenüberliegende Seitenwände die gleichen Abmessungen aufweisen und zwei einander gegenüberliegende Stirn- und/oder Seitenwände unterschiedliche Abmessungen zeigen, wodurch ein asymmetrischer Aufbau des Verpackungsbehälters resultiert. Dieser asymmetrische Aufbau kann sich beispielsweise abhängig vom zum verpackenden Gut als vorteilhaft erweisen.

In einer alternativen Ausführungsform können die Boden- und die Deckplatte polygonal, insbesondere sechs- oder achteckig, ausgebildet sein und eine entsprechende Anzahl von Seitenwänden aufweisen, wodurch Güter beliebiger Form verpackt und transportiert werden können, ohne dabei einen großen Leerraum im Verpackungs- bzw. Transportbehälter zu lassen.

Die Seitenwände können unabhängig davon, ob sie als Stirnwand ausgebildet sind, gleiche oder unterschiedliche Abmessungen aufweisen, wobei beispielsweise bei einer Ausführungsform eines achteckigen Behälters nicht sämtliche Seitenwände die gleiche Quererstreckung zeigen müssen. Vorteilhaft ist es allerdings, wenn die Längserstreckungen der Seitenwände die gleichen Abmessungen aufweisen um somit vom Deckelteil verschlossen werden zu können.

Der Bodenteil, Deckelteil, Seitenwände, Stirnwände und der Steg können auch mehrteilig ausgeführt sein, wobei für die Herstellung des Verpackungs- bzw. Transportbehälters auch kleinere Teile, welche sonst Abfall wären, verwendet werden können und somit sehr kostengünstig hergestellt werden können.

In einer bevorzugten Ausführungsform ist die Abmessung der Quererstreckung einer Seitenwand bzw. Stirnwand geringer, wie die Distanz zwischen zwei einander gegenüberliegenden, jeweils normal zur Seitenwand bzw. Stirnwand angeordneten Randstegen, wodurch die Seiten- bzw. Stirnwand im Leerzustand vorteilhafter Weise zwischen die Randstege der Bodenplatte gelegt werden können und somit der Verpackungs- bzw. Transportbehälter im Leerzustand ein sehr geringes Volumen einnimmt.

Die gleichen vorteilhaften Ausführungen wie zuvor gelten auch, wenn die Abmessung der Längserstreckung einer Seiten- bzw. Stirnwand geringer ist, wie die Distanz zwischen zwei einander gegenüberliegend, jeweils zur Seiten- bzw. Stirnwand angeordneten Randstegen. Hierbei kann die Seitenwand im Leerzustand des Verpackungsbehälters ebenfalls innerhalb der Randstege auf der Bodenplatte angeordnet werden und somit ein minimales Volumen einnehmen.

Die scharnierlose Ausbildung des Transport- und Verpackungsbehälters erweist sich auch von Vorteil, wenn der Bodenteil, Deckelteil, Seitenwände, Stirnwände und der Steg aus dem gleichen Material, insbesondere Holz, vorzugsweise Sperrholz, oder Kunststoff gebildet sind, weil dadurch ein sehr geringes Gewicht für den Transport- und Verpackungsbehälter erzielt wird. Zudem ist auch von Vorteil, dass durch die Verwendung lediglich eines Materials das Recycling deutlich vereinfacht wird, weil ein zeitaufwändiges Zerlegen und Trennen der Materialien entfällt.

In einer alternativen Ausftlhrungsform kann der Transport- und Verpackungsbehälter auch aus Holz und Kunststoff bestehen, wie beispielsweise holzverstärktem Kunststoff oder in das Sperrholz eingelagertes Kunststoffgranulat umfassen, um dadurch die Eigenschaften zu verbessern ohne dabei das Gewicht unnötig zu erhöhen, weil Materialien verwendet werden die ein sehr geringes Eigengewicht aufweisen.

In einer Weiterbildung des Transport- und Verpackungsbehälters können an den Ecken der Boden- bzw. der Deckplatte mit den Randstegen Kappen angeordnet sein, die einerseits die Randstege mit der Deck- bzw. Bodenplatte, gegebenenfalls zusätzlich, zusammenhalten können und andererseits einen Schutz der Ecken gewährleisten und somit die Lebenszeit des Transport- und Verpackungsbehälters verlängern.

In einer Weiterbildung der Erfindung können die Seitenwände und/oder die Boden- bzw. Deckplatte Ausnehmungen aufweisen, durch welche Verbindungsmittel ragen, wobei die Verbindungsmittel aus einer Gruppe umfassend Bänder, Seile, Gurte etc. ausgewählt sind, weil dadurch die Form des Transport- bzw. Verpackungsbehälters gesichert werden kann und somit auch bei sehr hohen mechanischen Beanspruchungen ein sicherer Transport des zu verpackenden Gutes möglich ist. Durch die gewählten Verbindungsmittel ist auch ein sehr einfaches Lösen derselben möglich und der Transport- und Verpackungsbehälter kann mit wenig Aufwand zerlegt werden.

In einer alternativen Ausführungsform können zur Verbindung der Seiten- bzw. Stirnwände. auch Winkel, Eckverbinder oder dgl. angeordnet sein, um zwei benachbarte Seitenwände miteinander zu verbinden um dadurch ein zusätzliches Stabilisierungselement des Transport- bzw. Verpackungsbehälters anzuordnen.

In der Gebrauchslage können die Stirnflächen zwei einander gegenüber angeordneter Stirnwände an der Innenseite der jeweils beiden gegenüberliegenden Seitenwände anliegen, wodurch die Stirnwände, insbesondere deren Stirnflächen, durch die frontale bzw. die dorsale Seitenwand des Verpackungs- bzw. Transportbehälters geschützt sind.

In einer alternativen Ausführungsform können in der Gebrauchslage die Stirnflächen zwei einander gegenüber angeordneter Seitenwände an der Innenseite der jeweils beiden gegenüberliegenden Stirnwände anliegen, wodurch die Stirnflächen der Seitenwände durch die Innenseite der Stirnwände geschützt sind, somit kann je nach zu erwartender mechanischer Beanspruchung eine entsprechende Anordnung der Stirn- bzw. Seitenwände bei viereckigem Grundriss des Transport- bzw. Verpackungsbehälters gewählt werden.

In einer alternativen Ausführungsform kann in der Gebrauchslage die Stirnfläche des ersten Randbereichs einer Seitenwand an der Innenseite im Randbereich der benachbarten Seitenwand anliegen und am zweiten Randbereich der selben Seitenwand die Innenseite an der Stirnfläche der gegenüber der ersten benachbarten Seitenwand angeordneten Seitenwand anliegen, wodurch ein eigenständiger Halt in Hinblick auf die Verhinderung des nach innen Fallens der Seitenwände zueinander des Transport- und Verpackungsbehälters gegeben ist. Ein nach außen Fallen wird durch die Randstege verhindert.

In einer weiteren alternativen Ausführungsform können in der Gebrauchslage die Stirnwände in einem Randbereich mit ihrer Innenfläche auf die Stirnkante der anliegenden Seitenwand und in entgegengesetzter Richtung mit ihrer Stirnfläche auf der Innenseite der anderen anliegenden Seitenwand anliegen bzw. die gleichen Ausführungen gelten für Seitenwände, wodurch abermals, je nach Bedarf und nach zu erwartender mechanischer Beanspruchung, eine entsprechende Anordnung der Seiten- bzw. der Stirnwände gewählt werden kann.

Durch die Anordnung von Verschlüssen, vorzugsweise mit einem Schnapp- und Drehmechanismus, an den Randstegen des Boden- und/oder Deckelteils bzw. den Seitenwänden oder darauf befestigten Stegen an der Außenseite der Seitenwände und/oder Stirnwände, wird eine stabile Verbindung der einzelnen Bauteile des Transport- und Verpackungsbehälters erreicht. Die erfindungsgemäßen Verschlüsse sind sehr leichtgängig, auch wenn sie gegen Widerstand geschlossen werden müssen und sind gegen versehentliches Öffnen geschützt.

In einer alternativen Ausführungsform kann anstelle der Deckplatte ein Zwischenboden angeordnet sein, wobei der Randsteg an der Stirnfläche des Zwischenbodens derart angeordnet ist, dass der Randsteg sowohl nach unten als auch nach oben über die Zwischenbodenplatte vorspringt, wodurch mehrere Transport- und Verpackungsbehälter Platz sparend übereinander angeordnet werden können.

Die Aufgabe der Erfindung wird auch eigenständig durch ein Verfahren zur Herstellung des erfindungsgemäßen Transport- und Verpackungsbehälters gelöst, wobei zumindest jeweils ein Randsteg in eine Haltevorrichtung eingelegt und fixiert wird, gegebenenfalls der fixierte Randsteg bewegt wird, bis die Ecken benachbarter Randstege aneinander stoßen bzw. interagieren oder alternativ ein vorgefertigter Rahmen in die Haltevorrichtung eingelegt und fixiert wird, die Boden- und Deckplatte auf die Randstege bzw. den Rahmen aus Randstegen positioniert wird, wobei die Stirnseiten der Boden- und Deckplatte mit den Randstegen oder die Stirnflächen mit der Außenseite der Boden- und Deckplatte zumindest annähernd bündig abschließen und zuletzt die Boden- und Deckplatte auf den Randstegen befestigt wird, wodurch das Herstellungsverfahren für den Boden- und Deckelteil automatisiert und somit deutlich beschleunigt werden kann.

Die Fixierung der Randstege in der Haltevorrichtung kann beispielsweise dadurch erfolgen, dass die Randstege in der Haltevorrichtung fixiert werden und die Haltevorrichtung selbst bewegt wird, oder dass die Haltevorrichtung bereits an der endgültigen Position ist und die Fixierung des Randstegs durch einen beweglichen Teil der Haltevorrichtung erfolgt, wobei diese beweglichen Teile z.B. über verschiedene Antriebe in einem vordefinierten Bereich bewegt werden können.

Beim Auflegen der Boden- und/oder Deckplatte auf die Randstege kann diese durch einen Vorsprung an der Haltevorrichtung justiert werden, wodurch auf vorteilhafte Weise die richtige Position der Boden- bzw. Deckplatte in Bezug auf die Randstege hergestellt wird und so mit ein mühsames und zeitintensives freies Justieren entfallen.

Der Transport- und Verpackungsbehälter eignet sich hervorragend für die Luftverfrachtung bzw. Verschiffung von Gütern, wie Maschinen, Spielboxen, medizinischen Geräten, etc., weil dieser per se ein sehr geringes Gewicht aufweist und somit kaum zusätzliche Transportkosten aufgrund von zusätzlichem Gewicht zu dem zu transportierenden Gut verursacht.

Zudem eignet sich der erfindungsgemäße Transport- und Verpackungsbehälters auch sehr gut zur Verpackung von Gütern in Räumen mit hoher Luftfeuchtigkeit bzw. zur Aufbewahrung von Gütern im Freien, weil durch die Materialwahl eine gute Haltbarkeit gegeben ist und sich das Material bei Kontakt mit Flüssigkeit, Wasserdampf, Schnee und dgl. nicht auflöst wie dies beispielsweise von Karton bekannt ist.

Zum besseren Verständnis der Erfindung wird diese anhand der nachfolgenden Figuren näher erläutert.

Es zeigt jeweils in stark vereinfachter, schematischer Darstellung:
- Fig. 1: eine Schrägansicht auf einen Transport- bzw. Verpackungsbehälter 1;
- Fig. 2: eine Schrägansicht auf eine alternative Ausführungsform eines Transport- bzw. Verpackungsbehälters 1;
- Fig. 3: eine Schrägansicht auf einen geschlossenen Transport- und Verpackungsbehälter 1;
- Fig. 4: eine Schrägansicht einer alternativen Ausführungsform eines Transport- bzw. Verpackungsbehälters 1;
- Fig. 5: eine Schrägansicht auf zwei übereinander gestapelte Transport- und Verpackungsbehälter 1.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mitumfasst sind, d.h. sämtliche Teilbereich beginnen mit einer unteren Grenze von 1 oder größer und enden bei einer oberen Grenze von 10 oder weniger, z.B. 1 bis 1,7, oder 3,2 bis 8,1 oder 5,5 bis 10.

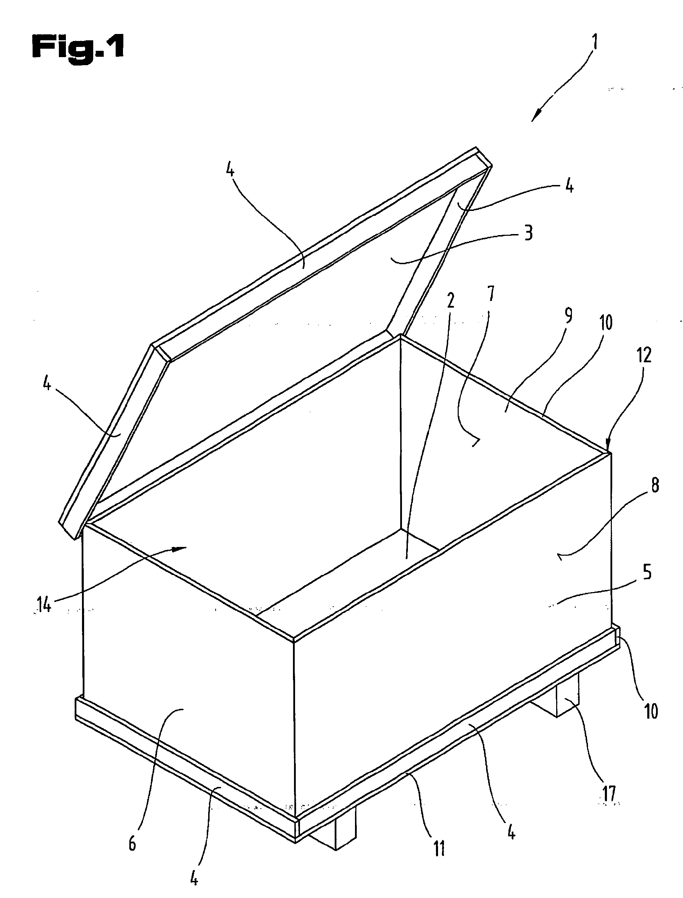

Fig. 1 zeigt einen erfindungsgemäßen Transport- und Verpackungsbehälter 1. Der Behälter umfasst einen Bodenteil und einen Deckelteil jeweils mit einer Bodenplatte 2, einer Deckplatte 3 und jeweils daran annähernd vertikal angeordneten Randstegen 4. Des weiteren umfasst der Verpackungs- und Transportbehälter 1 auch Seitenwände 5, insbesondere zwei Seitenwände 5 und zwei Stirnwände 6.

Sowohl die Bodenplatte 2, Deckplatte 3, Randstege 4 als auch die Seitenwände 5 bzw. Stirnwände 6 weisen eine Innenseite 7 und eine Außenseite 8 auf. Die Innenseite 7 ist jeweils zum Innenraum 14 des Transport- bzw. Verpackungsbehälters 1 und somit in Richtung des zu verpackenden Guts angeordnet und die Außenseite 8 der jeweiligen Bauteile ist in entgegengesetzter Richtung, also in Umgebungsrichtung, angeordnet. Zudem weisen die einzelnen Bauteile Randbereiche 9 auf, an welchen jeweils Stirnseiten 10 mit Stirnflächen 11 angeordnet sind.

Wie in Fig. 1 dargestellt, sind die Stirnflächen 11 der Seitenwände 5, die benachbart zur Stirnfläche 11 einer weiteren Seitenwand 5 angeordnet sind, auf Gehrung in Bezug auf die Innenseite 7 der jeweiligen Seitenwand 5 angeordnet. Die Winkel 12 der Stirnflächen 11 in Bezug auf die Innenseite 7 der Seitenwände 5 bzw. der Stirnwände 6 können aus einem Bereich mit einer oberen Grenze von 75°, vorzugsweise 65°, insbesondere 55° und einer unteren Grenze von 15°, vorzugsweise 25°, insbesondere 35° ausgewählt sein. In einer bevorzugten Ausführungsform und auch gezeigt, bildet die Gehrung die Winkelhalbierende des Winkels 12 der aufeinander treffenden Teile. Es ist allerdings auch denkbar, dass die Stirnflächen 11 nicht die Winkelhalbierende bilden und somit z.B. die Stirnfläche 11 einer Seitenwand 5 in Bezug auf die Innenseite 735° und die Stirnfläche 11 der dazugehörenden anderen Seitenwand 5 in Bezug auf die Innenseite 7 55° bildet.

In einer alternativen, nicht dargestellten Form können die Seitenwände 5 des Transport- und Verpackungsbehälters 1 auch auf einer polygonalen, z.B. hexagonalen, Bodenplatte 2 angeordnet sein, wobei somit entsprechend der Ausbildung des Transport- und Verpackungsbehälters 1 in Form eines Sechsecks der Winkel 12 einen entsprechenden Wert annimmt. Wie bereits beschrieben können die Stirnflächen 11 der Seitenwände 5 die Winkelhalbierende des Winkels 12 oder ein anderes Verhältnis aufweisen, d.h. bilden die beiden Seitenwände 5 einen Winkel 12 von 120° zueinander sind ihre Stirnflächen 11, z.B. auf 50° und 70° Gehrung, geschnitten.

In einer bevorzugten Ausführungsform ist der Transport- und Verpackungsbehälter 1 in Form eines geraden oder schiefen Prismas, insbesondere in Form eines Quaders, ausgebildet. Bei dieser Ausführungsform nimmt der Winkel 12 der Stirnfläche 11 im Randbereich 9 einer Seitenwand 5 bzw. einer Stirnwand 6 den Wert von 45° ein.

Ebenfalls in Fig. 1 ist eine Ausführungsform der Anordnung der Randstege 4 in Bezug auf die Bodenplatte 2 bzw. die Deckplatte 3 dargestellt. Die Randstege 4 sind auf der Innenseite 7 der Bodenplatte 2 bzw. der Deckplatte 3 angeordnet und die Stirnflächen 11 der Boden- bzw. Deckplatte 2,3 sind sichtbar.

In einer alternativen, nicht dargestellten Form können die Randstege 4 auch an den Stirnflächen 11 der Boden- bzw. Deckplatte 2,3 angeordnet sein, um das zur Verfügung stehende Platzangebot der Boden- bzw. Deckplatte 2,3 optimal nutzen zu können.

Werden die Randstege 4, wie in Fig. 1 dargestellt, auf der Innenseite 7 der Boden- bzw. Deckplatte 2,3 angeordnet, können sie beispielsweise mit einem Haftkleber mit der Platte verbunden werden. Sind die Randstege 4, wie in der alternativen, nicht dargestellten Ausführungsform, jeweils an den Stirnflächen der Boden- bzw. Deckplatte 2,3 angeordnet, so können sie beispielsweise auch mit Nägeln, Stiften oder Klammern befestigt sein.

Ist wie in Fig. 1 der Boden- oder/und Deckelteil rechteckig ausgebildet, so weisen die jeweils zwei einander gegenüberliegenden Seitenwände 5 und die Stirnwände 6 die gleichen Abmessungen auf.

Wie ebenfalls Fig. 1 zu entnehmen ist, ist die Abmessung der Quererstreckung 13 der Seiten-und Stirnwand 5,6 geringer wie die Distanz zwischen den zwei einander gegenüberliegend jeweils normal zur Seiten- bzw. Stirnwand 5,6 angeordneten Randstegen 4, somit können die Seitenwände 5 bzw. die Stirnwände 6 jeweils in Richtung des Innenraums 14 des Verpackungs- bzw. Transportbehälters 1 gelegt werden.

Ebenfalls aus Fig. 1 ist ersichtlich, dass die Abmessung der Längserstreckung 15 der Seiten-bzw. Stirnwand 5,6 geringer ist, wie die Distanz zwischen zwei einander gegenüberliegend, jeweils parallel zur Seiten- bzw. Stirnwand 5,6 angeordneten Randstegen 4. Somit können die Seiten- bzw. Stirnwände 5,6 auch in Bezug auf ihre Längserstreckung 15 innerhalb der Randstege 4 der Bodenplatte 2 angeordnet werden, um so ein minimalstes Verpackungsvolumen des Behälters 1 im Leerzustand erzielen zu können.

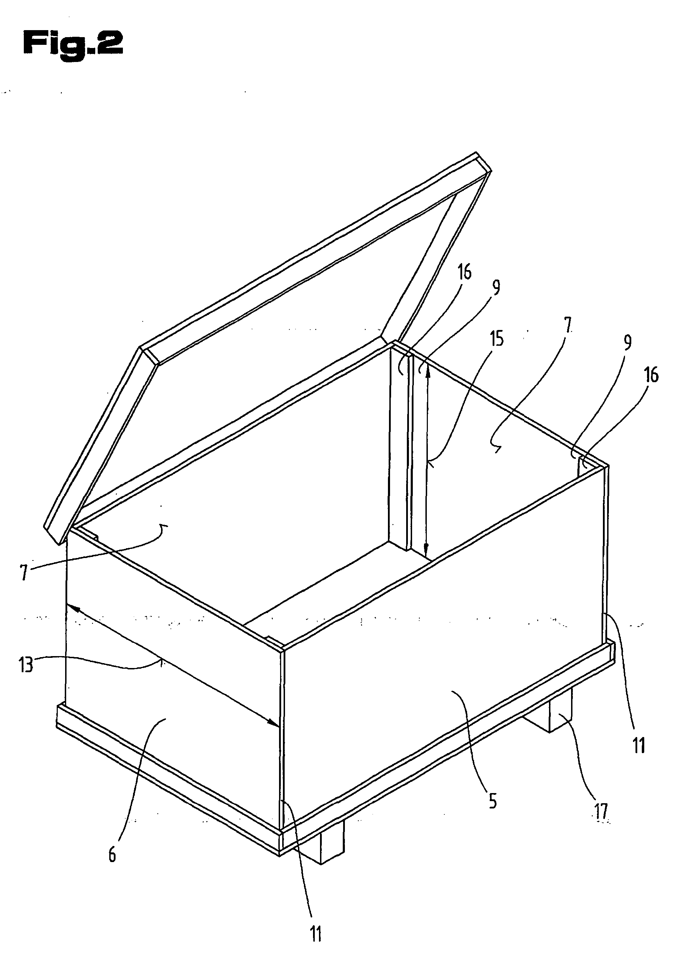

In Fig. 2 ist eine alternative Ausführungsform des zerlegbaren Transport- und Verpackungsbehälters 1 dargestellt. Bei dieser alternativen Ausführungsform sind die Seitenwände 5 zwar ebenfalls scharnierlos auf der Bodenplatte 2 angeordnet, allerdings sind an zumindest zwei Seitenwänden 5 in zumindest einem Randbereich 9 der Innenseite 7 Stege 16 angeordnet. Der Steg 16 kann, wie in Fig. 2 dargestellt, in den Randbereichen 9 von jeweils zwei einander gegenüber angeordneten Stirnwänden 6 angebracht sein.

Ebenfalls aus Fig. 2 ist ersichtlich, dass in der Gebrauchslage die Stirnflächen 11 zwei einander gegenüber angeordneter Seitenwände 5 an der Innenseite 7 der jeweils beiden gegenüberliegenden Stirnwände 6 anliegen.

In einer alternativen, nicht dargestellten Ausführungsform können in der Gebrauchslage die Stirnflächen 11 zwei einander gegenüber angeordneter Stirnwände 6 an den Innenseiten 7 der jeweils beiden gegenüber liegenden Seitenwände 5 anliegen. Bei dieser Ausführungsform sind die Stege 16 jeweils im Randbereich 9 der Seitenwand 5 angeordnet.

Weisen die jeweils zwei einander gegenüber angeordneten Seiten- und Stirnwände 5, 6 die gleichen Abmessungen auf, so kann in der Gebrauchslage die Stirnfläche 11 des ersten Randbereichs 9 einer Seitenwand 5 an der Innenseite 7 im Randbereich 9 der benachbarten Stirnwand 6 anliegen und am zweiten Randbereich 9 der selben Seitenwand 5 die Innenseite 7 derselben an der Stirnfläche 11 der gegenüber der benachbarten Stirnwand 6 angeordneten Stirnwand 6 anliegen.

In einer alternativen, nicht dargestellten Ausführungsform können die zwei einander gegenüberliegende Seitenwände 5 und die zwei einander gegenüberliegenden Stirnwände 6 unterschiedliche Abmessungen zeigen und somit alle Seitenwände 5 unterschiedliche Abmessungen aufweisen, womit eine nicht dargestellte Anordnung der Seiten- und Stirnwände 5, 6 zueinander erzielt werden kann. Diese ist in Gebrauchslage folgender Weise: eine Stirnwand 6 liegen in einem Randbereich 9 mit ihrer Innenseite 7 auf der Stirnseite 10 der anliegenden Seitenwand 5 und in entgegengesetzter Richtung mit ihrer Stirnfläche 11 auf der Innenseite 7 der anderen anliegenden Seitenwand 5 an. Die gegenüber der ersten Stirnwand 6 angeordnete Stirnwand 6 liegt mit ihrer Innenseite 7 in einem Randbereich 9 der Stirnfläche 11 der Seitenwand 5 und am entgegengesetzten Ende liegt die Stirnfläche 11 der Stirnwand 6 der Innenseite 7 der Seitenwand 5 an.

In einer weiteren nicht dargestellten Ausführungsform können auch zwei einander gegenüber angeordnete Stirnwände 6 die gleichen Abmessungen aufweisen und die beiden einander gegenüberangeordneten Seitenwände 5 unterschiedliche Abmessungen zeigen, wodurch z.B. die eine Seitenwand 5 mit beiden Stirnflächen den Innenseiten 7 der gegenüber angeordneten Stirnwände 6 anliegt und die weitere Seitenwand mit der Innenseite 7 den Stirnflächen der Stirnwände 6 anliegt.

Selbstverständlich kann bei allen angeführten Varianten auch die Anordnung der Seiten-und Stirnwände 5, 6 vertauscht werden.

Der Steg 16 kann, wie in Fig. 2 dargestellt, von einer durchgehenden Leiste, welche über die gesamte Längserstreckung 15 im Randbereich 9 einer Seitenwand 5 angeordnet ist, gebildet sein. In einer alternativen, nicht dargestellten Ausführungsform kann der Steg 16 auch in Form eines Knaufs, Knopfes, Dübels oder einer anderen beliebigen Erhabenheit ausgebildet sein.

Ebenfalls nicht dargestellt ist die Anordnung der Stege 16 nur bereichsweise. So kann beispielsweise der Steg 16 nur im Randbereich 9 im oberen und/oder unteren Bereich einer Seiten- bzw. Stirnwand 5, 6 angeordnet sein.

Der Steg 16 ist vorzugsweise mit Nägel mit der Seiten- bzw. Stirnwand 5,6 verbunden. In alternativen Ausführungsformen ist es selbstverständlich auch möglich, den Steg 16 durch Klammern, Haftkleber, Schrauben oder dgl. an der Stirn- oder Seitenwand 5,6 zu befestigen.

In einer weiteren alternativen Ausführungsform ist es auch möglich den Steg 16 einstückig mit der Seiten- bzw. Stirnwand 5, 6 herzustellen. Bei der Ausbildung des Transport- und Verpackungsbehälters 1 aus Holz kann dies z.B. durch Wegfräsen von Teilen der Seiten- bzw. Stirnwand 5, 6 erfolgen bzw. bei der Ausbildung des Transport- und Verpackungsbehälters 1 aus Kunststoff können die Seiten- bzw. Stirnwand 5, 6 einteilig hergestellt, insbesondere gespritzt, werden.

Ebenfalls nicht dargestellt ist die polygonale, insbesondere sechs- oder achteckige Ausbildung der Boden- und Deckplatte 2, 3. Bei dieser alternativen Ausführungsform ist eine entsprechende Anzahl an Seitenwänden 5-angeordnet. Die Seitenwände 5 können dabei gleiche oder unterschiedliche Abmessungen aufweisen, je nach Länge der jeweiligen Seitenkante des Polygons.

In einer weiteren alternativen Ausführungsform können die Bodenplatte 2, die Deckplatte 3, die Seitenwände 5, die Stirnwände 6 und der Steg 16 mehrteilig ausgeführt sein. Dies kann sich beispielsweise dann als zweckmäßig erweisen, wenn der Transport- und Verpackungsbehälter 1 beispielsweise aus Reststücken eines den Verpackungsbehälter 1 bildenden Materials hergestellt wird.

Die Bodenplatte 2, die Deckplatte 3, die Seitenwände 5, die Stirnwände 6 und der Steg 16 können aus dem gleichen Material, insbesondere Holz, vorzugsweise Sperrholz, gebildet sein, wodurch eine äußerst kostengünstige, aber dennoch wieder verwendbare Ausführungsform des Verpackungs- bzw. Transportbehälters 1 hergestellt werden kann.

Alternativ können die Bodenplatte 2, die Deckplatte 3, die Seitenwände 5, die Stirnwände 6 und der Steg 16 auch aus Kunststoff oder aus Kunststoff und Holz bestehen, wie z.B. holzverstärktem Kunststoff oder bereichsweise aus Holz und bereichsweise aus Kunststoff gebildet sein.

Wie in Fig. 1 und 2 dargestellt, kann die Bodenplatte 2 lediglich auf zwei Staffeln 17 bzw. Kanthölzern angeordnet sein.

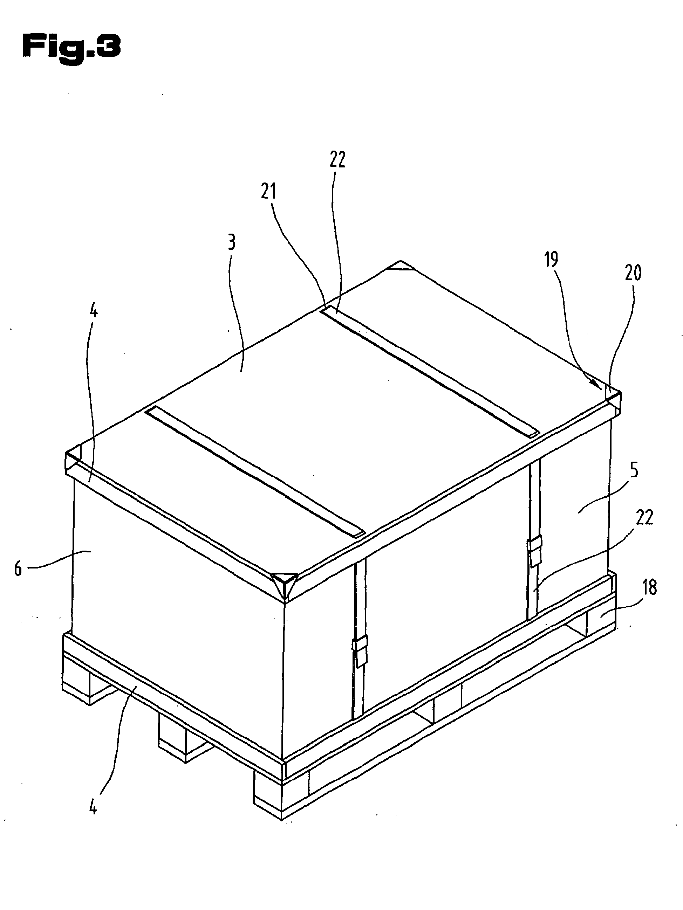

In einer alternativen Ausführungsform wie in Fig. 3 dargestellt, kann die Bodenplatte 2 auch auf einer Palette 18, insbesondere aus Holz, angeordnet sein bzw. kann die Palette 18 die Bodenplatte 2 bilden. Um eine standardisierte Ausführung des Verpackungs- bzw. Transportbehälters 1 zu ermöglichen, wird bevorzugt eine Europalette verwendet.

Als zusätzliche bzw. weitere Verbindungen zweier benachbarter Seitenwände 5 können beispielsweise auch Winkel oder Eckverbinder, die sich in Form eines Stabes diagonal über die Ecke zweier benachbarter Seitenwände erstrecken, angeordnet sein.

Fig. 3 zeigt einen Transport- und Verpackungsbehälter 1 mit zusätzlichen Ausstattungsvarianten, um die Stabilität bzw. die Haltbarkeit zu verbessern. So können beispielsweise im Bereich der Ecken 19 der Boden- bzw. Deckplatte 2,3 mit den Randstegen 4 Kappen 20 angeordnet sein. Die Kappen 20 können auch nur an ausgewählten, mechanisch besonders beanspruchten Ecken 19 angeordnet sein.

Als weiteres zusätzliches Ausstattungsmerkmal können in der Boden- bzw. Deckplatte 2,3 Ausnehmungen 21 angeordnet sein, durch welche Verbindungsmittel 22 ragen. In einer alternativen, nicht dargestellten Ausführungsform können die Ausnehmungen 21 selbstverständlich auch in den Seitenwänden bzw. Stirnwänden 5,6 angeordnet sein.

Als Verbindungsmittel 22 kommen Bänder, Seile, Gurte etc. in Frage. In Fig. 3 ist die Verwendung von Gurten dargestellt.

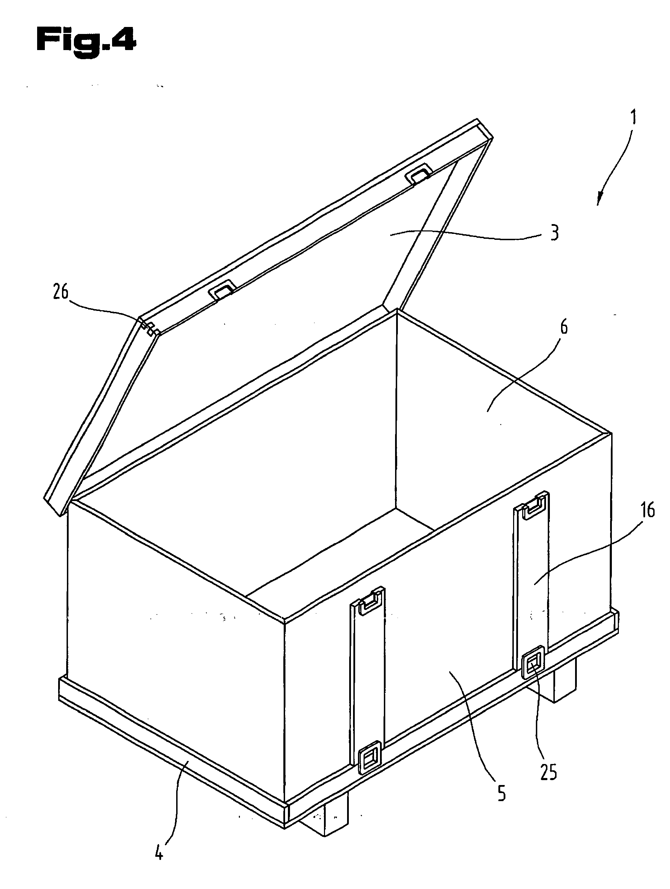

In einer alternativen Ausführungsform können, wie in Fig. 4 dargestellt, an der Außenseite 8 der Seitenwände 5 Stege 16 angeordnet sein. In diesen Stegen 16 und in den Randstegen 4 sind Ausnehmung vorgesehen, in welchen Verschlüsse 25, z.B. Butterflyverschlüsse, angeordnet sind, um eine transportsichere Verpackung zur Verfügung zu stellen. Die Verschlüsse 25 können auch auf an der Oberfläche der zu verbindenden Teile angeordnet sein und müssen nicht notwendigerweise in einer Ausnehmung vorliegen.

Ebenfalls in Fig. 4 ist eine alternative Ausführungsform zum Verbinden der Randstege 4 dargestellt. An den Ecken sind die Randstege 4 über Fingerzinken 26 miteinander verbunden, um einer starken mechanischen Beanspruchung zu widerstehen.

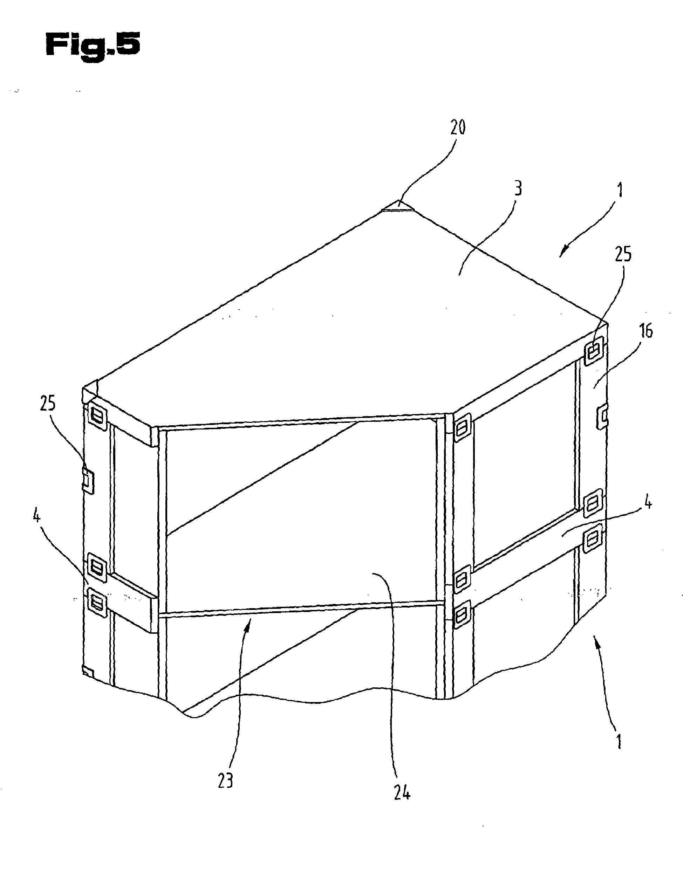

Fig. 5 zeigt eine alternative Ausführungsform der Erfindung, wobei der Deckelteil eines erfindungsgemäßen Transport- und Verpackungsbehälters 1 durch einen Zwischenboden 23 ersetzt wird. Es können somit mehrere Transport- und Verpackungsbehälter 1 übereinander gestapelt werden. Der Zwischenboden 23 umfasst eine Zwischenbodenplatte 24 und Randstege 4, die an den Stirnflächen 11 der Zwischenbodenplatte 24 angeordnet sind. Dieser Zwischenboden 23 dient zugleich als Bodenteil 2 des weiteren Transport- und Verpackungsbehälters 1, er auf dem ersten Transport- und Verpackungsbehälter 1 angeordnet ist.

Die Erfindung ist selbstverständlich nicht auf die Anzahl der in Fig. 5 dargestellten Transport-und Verpackungsbehälter 1 beschränkt.

Die Abmessungen der Seiten- bzw. Stirnwände 5, 6 und der Boden- bzw. Deckplatte 2, 3 bzw. der anderen Bestandteile des Transport- und Verpackungsbehälters 1 können frei gewählt werden um beispielsweise den Anforderungen bestimmter Normen zu entsprechen.

Der Transport- und Verpackungsbehälter 1 eignet sich insbesondere für den Transport, insbesondere für Luftfrachten oder für die Verschiffung von großen, sperrigen Gütern wie Maschinen, Spielboxen, medizinischen Geräten, etc.

Zudem kann der Transport- und Verpackungsbehälter 1 auch für die Aufbewahrung von Gütern in Räumen mit hoher Luftfeuchtigkeit bzw. im Freien verwendet werden.

Es wurden allgemein alle Seitenwände 5 als Seitenwände 5 bezeichnet, wobei zum besseren Verständnis in der speziellen Figurenbeschreibung eine Präzisierung vorgenommen wurde und die Seitenwände 5 in Seitenwände 5 und Stirnwände 6 gegliedert wurden, wobei allerdings selbstverständlich auch Stirnwände 6 Seitenwände 5 sind.

Der Ordnung halber sei abschließend darauf hingewiesen, dass zum besseren Verständnis des Aufbaus des Transport- und Verpackungsbehälters 1 dieser bzw. dessen Bestandteile teilweise unmaßstäblich und/oder vergrößert und/oder verkleinert dargestellt wurden.

Die den eigenständigen erfinderischen Lösungen zugrunde liegende Aufgabe kann der Beschreibung entnommen werden.

Die Ausführungsbeispiele zeigen mögliche Ausführungsvarianten des Transport- und Verpackungsbehälters 1, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mitumfasst.

Vor allem können die einzelnen in den Fig. 1 bis 5 gezeigten Ausführungen den Gegenstand von eigenständigen, erfindungsgemäßen Lösungen bilden.

### Bezugszeichenaufstellung

- 1: Behälter
- 2: Bodenplatte
- 3: Deckplatte
- 4: Randsteg
- 5: Seitenwand

- 6: Stirnwand
- 7: Innenseite
- 8: Außenseite
- 9: Randbereich
- 10: Stirnseite

- 11: Stirnfläche
- 12: Winkel
- 13: Quererstreckung
- 14: Innenraum
- 15: Längserstreckung

- 16: Steg
- 17: Staffel
- 18: Palette
- 19: Ecke
- 20: Kappe

- 21: Ausnehmung
- 22: Verbindungsmittel
- 23: Zwischenboden
- 24: Zwischenbodenplatte
- 25: Verschluss

- 26: Zinken

## Patentansprüche

1. Zerlegbarer Transport- und Verpackungsbehälter (1) mit abnehmbarem Boden- und Deckelteil mit jeweils annähernd vertikal angeordneten Randstegen (4) sowie an der Bodenplatte (2) entlang den Randstegen (4) aufstellbaren Seitenwänden (5), insbesondere zwei Seiten- (5) und zwei Stirnwänden (6) mit Randbereichen (9) an ihrer Innen- (7) und Außenseite (8) und mit Stirnseiten (10) bzw. -flächen (11), **dadurch gekennzeichnet, dass** die Seitenwände (5) zueinander und in Bezug auf den Boden- und Deckelteil scharnierlos angeordnet sind und an zumindest zwei Seitenwänden (5) in zumindest einem Randbereich (9) der Innenseite (7) zumindest ein Steg (16) ausgebildet bzw. angeordnet ist und/oder die Stirnseiten (10) der Seitenwände (5), die benachbart zur Stirnfläche (11) einer weiteren Seitenwand (5) angeordnet sind, auf Gehrung in Bezug auf die Innenseite (7) der jeweiligen Seitenwand (5) angeordnet sind.

2. Transport- und Verpackungsbehälter (1) nach Anspruch 1, **dadurch gekennzeichnet, dass** die Stirnflächen (11) in Bezug auf die Innenseite (7) der Seitenwände (5) einen Winkel (12) aus einem Bereich mit einer unteren Grenze von 35 und einer oberen Grenze von 55 ° aufweisen.

3. Transport-und Verpackungsbehälter (1) nach Anspruch 1 oder 2, **dadurch gekennzeichnet, dass** der Steg (16) einstückig mit der Seitenwand (5) oder separat an der Seitenwand (5) und durch eine Erhebung wie Leiste, Knauf, Knopf, oder ähnlichem gebildet ist.

4. Transport- und Verpackungsbehälter (1) nach einem der Ansprüche 1 bis 3, **dadurch gekennzeichnet, dass** der Steg (16) durchgehend oder nur bereichsweise über die Längserstreckung (15) im Randbereich (9) einer Seitenwand (5) ausgebildet bzw angeordnet ist.

5. Transport- und Verpackungsbehälter (1) nach einem der Ansprüche 1 bis 4, **dadurch gekennzeichnet, dass** der zumindest eine Steg (16) an einer Stirn- oder Seitenwand (5, 6) durch Nägel, Schrauben, Klammern, Kleber, etc. befestigt ist.

6. Transport- und Verpackungsbehälter (1) nach einem der Ansprüche 1 bis 5, **dadurch gekennzeichnet, dass** die Randstege (4) jeweils an den Stirnseite (10) im Randbereich (9) der Innenseite (7) der Boden- und/oder Deckplatte (2, 3) angeordnet sind.

7. Transport- und Verpackungsbehälter (1) nach einem der Ansprüche 1 bis 6, **dadurch gekennzeichnet, dass** die Randbereiche benachbarter Randstege (4) über Zinken, insbesondere Fingerzinken, offene Zinkung, halbverdeckte Zinkung, Gehrungszinkung, miteinander verbunden sind.

8. Transport- und Verpackungsbehälter nach einem der Ansprüche 1 bis 7, **dadurch gekennzeichnet, dass** die Boden- und Deckplatte (2, 3) polygonal, insbesondere sechs- oder achteckig ausgebildet sind, und eine entsprechende Anzahl an Seitenwänden (5) angeordnet ist.

9. Transport- und Verpackungsbehälter (1) nach einem der Ansprüche 1 bis 8, **dadurch gekennzeichnet, dass** der Bodenteil, Deckelteil, Seitenwände (5), Stirnwände (6) und Steg (16) mehrteilig ausgeführt sind.

10. Transport- und Verpackungsbehälter (1) nach einem der Ansprüche 1 bis 9, **dadurch gekennzeichnet, dass** der Bodenteil Deckelteil, Seitenwände (4), Stirnwände (5) und der zumindest eine Steg (16) aus dem gleichen Material, insbesondere Holz, vorzugsweise Sperrholz und/oder Kunststoff, gebildet sind.

11. Transport- und Verpackungsbehälter (1) nach einem der Ansprüche 1 bis 10, **dadurch gekennzeichnet, dass** die Bodenplatte (2) auf einer Palette, insbesondere aus Holz, angeordnet ist bzw. die Palette die Bodenplatte (2) bildet.

12. Transport- und Verpackungsbehälter (1) nach einem der Ansprüche 1 bis 11, **dadurch gekennzeichnet, dass** an den Ecken (19) der Boden- bzw. der Deckplatte (2, 3) mit den Randstegen (4) Kappen (20) angeordnet sind.

13. Transport- und Verpackungsbehälter (1) nach einem der Ansprüche 1 bis 12, **dadurch gekennzeichnet, dass** in den Seitenwänden (5) und/oder in der Boden- bzw. Deckplatte (2, 3) Ausnehmungen (21) angeordnet sind, durch welche Verbindungsmittel (22) ausgewählt aus einer Gruppe umfassend Bänder, Seile, Gurte, etc. ausgewählt sind.

14. Transport- und Verpackungsbehälter (1) nach einem der Ansprüche 1 bis 13, **dadurch gekennzeichnet, dass** Winkel oder Eckverbinder zur Verbindung zweier benachbarter Seitenwände (5) angeordnet sind.

15. Transport- und Verpackungsbehälter (1) nach einem der Ansprüche 1 bis 14, **dadurch gekennzeichnet, dass** an den Randstegen (4) der Boden- und/oder Deckelteils bzw. den Seitenwänden (5) oder darauf befestigten Stegen (16) an der Außenseite (8) der Seitenwände (5) und/oder Stirnwände (6) zumindest ein Verschluss (25), vorzugsweise mit einem Schnapp- und Drehmechanismus, angeordnet ist.

16. Transport- und Verpackungsbehälter (1) nach einem der Ansprüche 1 bis 15, **dadurch gekennzeichnet, dass** anstelle der Deckplatte (3) ein Zwischenboden (23) angeordnet ist, wobei der Randsteg (4) an der Stirnfläche (11) des Zwischenbodens (23) derart angeordnet ist, dass der Randsteg (4) sowohl nach unten als auch nach oben über die Zwischenbodenplatte (24) vorspringt.

17. Verfahren zur Herstellung eines Boden- und Deckelteils, aus Randstegen (4) und einer Boden- (2) oder Deckplatte (3) umfassend die Schritte a) einlegen jeweils eines Randsteges (4) in eine Haltevorrichtung, wobei die Randstege (4) fixiert werden, b) gegebenenfalls bewegen der fixierten Randstege (4) bis die Ecken benachbarter Randstege (4) aneinander stoßen bzw. interagieren oder alternativ zu Schritt a) und b) einlegen und fixieren eines vorgefertigten Rahmens aus Randstegen (4) in der Haltevorrichtung, c) positionieren der Boden- (2) und Deckplatte (3) auf die Randstege (4) bzw. den Rahmen aus Randstegen (4), wobei die Stirnseiten (11) der Boden- (2) bzw. Deckplatte (3) mit den Randstegen (4) oder die Stirnflächen (11) mit der Außenseite (8) der Boden- (2) und Deckplatte (3) bündig abschließen, d) befestigen der Boden- (2) und Deckplatte (3) auf den Randstegen.

18. Verfahren nach Anspruch 17, **dadurch gekennzeichnet, dass** die Randstege (4) über die Haltevorrichtung in einem vordefinierten Bereich bewegt werden.

19. Verfahren nach Anspruch 17 oder 18, **dadurch gekennzeichnet, dass** die Boden- (2) und/oder Deckplatte (3) durch einen Vorsprung an der Haltevorrichtung justiert wird.

20. Verwendung des zerlegbaren Transport- und Verpackungsbehälters (1) nach einem der Ansprüche 1 bis 16 als Mehrweggebinde.
